Europäisches Patentamt

**European Patent Office**

Office européen des brevets

(19)

(11) Numéro de publication: **0 127 239**
**B1**

(12)

# FASCICULE DE BREVET EUROPEEN

(45) Date de publication du fascicule du brevet:
**26.08.87**

(21) Numéro de dépôt: **84200744.5**

(22) Date de dépôt: **23.05.84**

(51) Int. Cl.⁴: **H 01 L 33/00**, G 09 F 9/33

(54) **Elément de panneau d'affichage à cristaux semi-conducteurs et panneau comportant ledit élément.**

(30) Priorité: **30.05.83 FR 8308921**

(43) Date de publication de la demande:
**05.12.84 Bulletin 84/49**

(45) Mention de la délivrance du brevet:
**26.08.87 Bulletin 87/35**

(84) Etats contractants désignés:
**DE FR GB**

(56) Documents cités:
**EP - A - 0 002 529**
**US - A - 3 914 786**
**US - A - 4 013 915**
**US - A - 4 152 624**

(73) Titulaire: **RTC-COMPELEC, 130, Avenue Ledru-Rollin,
F-75011 Paris (FR)**
(84) Etats contractants désignés: **FR**

(73) Titulaire: **N.V. Philips' Gloeilampenfabrieken,
Groenewoudseweg 1, NL-5621 BA Eindhoven (NL)**
(84) Etats contractants désignés: **DE GB**

(72) Inventeur: **Thillays, Jacques, Société Civile
S.P.I.D. 209, Rue de L'Université, F-75007 Paris (FR)**

(74) Mandataire: **Pinchon, Pierre et al, Société Civile
S.P.I.D. 209 rue de l'Université, F-75007 Paris (FR)**

## Description

La présente invention concerne un élément de panneau d'affichage formé essentiellement d'une pluralité de cristaux semi-conducteurs dans chacun desquels sont créées au moins deux régions de types de conduction opposés formant une jonction électroluminescente et situés au fond de cavités réfléchissant la lumière émise par ces cristaux, lesdites cavités créées dans des bandes de longueur déterminée, étant disposées soit en lignes, soit en colonnes, soit encore en une combinaison de lignes et de colonnes selon une configuration préalablement choisie et chacune d'entre elles comportant au moins deux plages métalliques de connexion mises respectivement en contact des deux régions du cristal semi-conducteur situé au fond.

Les éléments électroluminescents sont souvent utilisés par groupes dans une disposition établie en coordonnées X–Y.

Dans le plus grand nombre d'applications connues jusqu'à présent, ces éléments électroluminescents qui forment ainsi une matrice, généralement des diodes semi-conductrices, doivent être disposés en quantité importante sur une surface réduite et l'émission des rayonnements de chacun d'entre eux doit, en outre, être localisée dans une zone sensiblement ponctuelle, leur intensité lumineuse étant renforcée par la suite à l'aide d'un système optique approprié.

L'une des applications possibles d'un tel assemblage concerne la signalisation routière ou automobile, notamment des feux de carrefour ou des feux arrières ou de changement de direction de véhicules automobiles, mais dans ce cas, compte tenu des dimensions imposées à ces feux, un effort a dû être fait concernant le rapport:

nombre de cristaux, unité de surface

de manière à diminuer le coût de l'assemblage.

Un exemple en est fourni dans la demande de brevet français FR-A-2 524 155, qui décrit un assemblage, d'une part d'une pluralité de diodes électroluminescentes portées par un support approprié, et d'autre part, d'un conduit de lumière formé d'un système catadioptique centré constitué d'un réflecteur de même axe optique.

Dans ce conduit de lumière, l'optique comporte une lame à faces parallèles dans la partie centrale de laquelle est inclus un élément convergent épais à dioptres sphériques et le réflecteur est constitué d'un miroir concave à double quadrique associé à un miroir plan perpendiculaire à l'axe optique et formé du support des diodes.

Cependant, du point de vue efficacité, l'assemblage décrit dans cette demande de brevet n'apporte pas les résultats escomptés.

Du point de vue de l'optique, par exemple, l'expérience montre en effet que la lame à faces parallèles et l'élément convergent répondent à une demande bien précise de directivité du faisceau lumineux mais que tout choix de directivité différente même légère nécessitera une nouvelle optique, ce qui rend alors le conduit de lumière onéreux.

Par ailleurs, malgré la faible consommation de courant des éléments électroluminescents, leur accumulation sur le support isolant qui les porte conduit à des problèmes thermiques qui ont des répercussions également sur l'efficacité lumineuse. On peut estimer, par exemple, à 4 watts la puissance dissipée par 50 diodes et transformée en calories: ces calories, difficilement écoulées à travers le support provoquent une élévation de la température de l'assemblage qui conduit à une diminution de l'efficacité lumineuse dans un rapport pouvant atteindre 0,7% par °C.

Cette élévation de température peut provoquer également des dégradations de la plupart des matériaux constituant généralement le réflecteur.

En effet, si ce dernier est constitué d'une matière plastique recouverte d'un vernis puis d'une pellicule métallique déposée par un procédé de métallisation sous vide, et d'un autre vernis de protection, ladite pellicule présente alors des défauts d'adhérence et les vernis eux-mêmes peuvent se boursoufler ou se craqueler.

Quant au support isolant portant le ou les conduits de lumière, il est constitué d'un circuit dit «imprimé» parce qu'il porte un réseau de connexions nécessaire aux liaisons électriques des éléments électroluminescents entre eux et avec l'extérieur.

A priori, un circuit imprimé est conçu pour le montage de composants électroniques pré-étamés et soudés à la vague à des températures relativement basses mais, en grandes surfaces, il est mal adapté au soudage direct de cristaux semi-conducteurs à l'aide de résines conductrices qui ne polymérisent correctement qu'à des températures de l'ordre de 200 °C et surtout au soudage de fils de connexion. De plus, le circuit imprimé se prête mal à un assemblage modulaire à un pas constant.

La présente invention a pour but de remédier à ces inconvénients.

En effet, la présente invention concerne un élément de panneau d'affichage formé essentiellement d'une pluralité de cristaux semi-conducteurs dans chacun desquels sont créées au moins deux régions de types de conduction opposés formant une jonction électroluminescente et situés au fond de cavités réfléchissant la lumière émise par ces cristaux, lesdites cavités, créées dans des bandes de longueur déterminée, étant disposées soit en lignes, soit en colonnes, soit encore en une combinaison de lignes et de colonnes selon une configuration préalablement choisie et chacune d'entre elles comportant au moins deux plages métalliques de connexion mises respectivement en contact des deux régions du cristal semi-conducteur situé au fond, élément notamment remarquable en ce que chacune des bandes est constituée de deux rangées de demi-coquilles disposées dos à dos, et engendrant des portions de cavité complémentaires, lesdites demi-coquilles de la première rangée comportant au fond le support et la première plage de connexion des cristaux semi-conducteurs et les demi-coquilles de la seconde rangée comportant au fond une plage métallique de prise de contact constituant la seconde connexion desdits cristaux et en ce qu'au moins deux bandes identiques sont associées de façon à être isolées entre elles dans une disposition engendrant une suite de cavités.

Cet élément de panneau d'affichage présente de nombreux avantages dus notamment à sa forme, au choix des matériaux employés et à la simplicité de sa réalisation.

En effet, l'idée de créer une série de cavités par association de bandes comportant une pluralité de demi-coquilles facilite leur agencement et permet d'accroître le nombre de possibilités de création de nouvelles formes. Elle permet, par ailleurs, d'augmenter la rapidité de réalisation d'un panneau d'affichage et de rendre automatisable ladite réalisation.

Dans le brevet français FR-A-2 378 325, déposé par la Demanderesse, est décrit un élément d'affichage comportant également deux demi-coquilles mais dont l'application et la réalisation sont différentes: il s'agit, en effet, dans ce cas, de réaliser un élément lumineux en forme de barre destiné à l'élaboration d'un dispositif d'affichage alphanumérique. En outre, cet élément utilise un cristal semi-conducteur électroluminescent émettant la lumière par la tranche de telle sorte que les deux demi-coquilles serrent entre elles ledit cristal qui ne repose donc pas sur le fond de l'une d'entre elles.

Dans une première forme de réalisation, la plus simple à mettre en œuvre, les demi-coquilles de deux rangées d'une même bande engendrent des portions de cavité de volume égal et sont symétriques par rapport au plan perpendiculaire à ladite bande et séparant celle-ci en deux parties égales correspondant aux deux rangées de demi-coquilles.

Cette forme de réalisation est surtout intéressante dans le cas où un léger décentrage de l'axe optique du cristal semi-conducteur par rapport à l'axe optique de la cavité n'est pas incompatible avec le but recherché.

Dans une seconde forme de réalisation, les demi-coquilles des deux rangées d'une même bande engendrent deux portions de cavité complémentaires de volumes différents, les demi-coquilles servant de support aux cristaux semi-conducteurs étant, d'une part, de volume supérieur à celui des demi-coquilles servant de support à la seconde connexion et, d'autre part, portant en totalité lesdits cristaux de manière telle que ceux-ci soient centrés sur l'axe optique des cavités qu'elles engendrent avec les demi-coquilles complémentaires.

Cette forme de réalisation a pour but d'obtenir d'une manière simple, rapide et reproductible une série de cavités identiques dans lesquelles les sources lumineuses créées dans les cristaux semi-conducteurs sont bien centrées.

Dans un mode de mise en œuvre avantageux de ces formes de réalisation, chaque cristal semi-conducteur est fixé sur un bossage élaboré sur le fond de la demi-coquille qui lui sert de support. Dans ce cas, la localisation et la mise en place du cristal s'en trouvent notablement facilitées.

De même, le point de contact entre la demi-coquille servant de seconde connexion des cristaux et le fil de liaison avec la région correspondante desdits cristaux peut être également élaborée sur un bossage formé au fond de ladite demi-coquille.

Si l'on envisage de recouvrir les cristaux semi-conducteurs d'une goutte de résine transparente servant à la fois de protection et de système optique d'adaptation d'indices de réfraction, la création de cette goutte de résine sera facilitée par la présence des bossages des deux demi-coquilles en regard:

— par exemple, si l'ensemble de deux bossages de demi-coquilles en regard représente une forme géométrique sensiblement circulaire, la goutte de résine déposée à leur surface sera hémisphérique.

Suivant le but recherché, la forme des demi-coquilles peut être différente. En effet, lesdites demi-coquilles peuvent être conçues pour forme des cavités à faces internes paraboliques ou des cavités à faces internes planes.

Selon les applications envisagées, les demi-coquilles peuvent être réalisées à partir de bandes métalliques relativement malléables, conductrices de l'électricité et soutenues par une semelle en matière plastique isolante, lesdites bandes métalliques étant alors mises en forme par matriçage ou emboutissage. Dans le cas desdites bandes métalliques, le métal choisi présentera, de préférence, un pouvoir réfléchissant élevé et une bonne conductibilité thermique.

L'utilisation de demi-coquilles permet d'obtenir simultanément les prises de contact des cristaux semi-conducteurs et les cavités réfléchissantes. Eventuellement, elle peut permettre aussi l'assemblage des bandes entre elles par collage à température élevée à l'aide de matières isolantes, polymérisation d'une résine époxyde par exemple, et le soudage direct des cirstaux, ce qui a pour résultat de réduire le coût de fabrication.

Lesdites demi-coquilles peuvent être également en matière synthétique isolante et rigide, éventuellement transparente, recouverte au moins partiellement d'une couche métallique à pouvoir réfléchissant élevé et conductrice de l'électricité destinée à former les connexions nécessaires aux cristaux semi-conducteurs.

Les demi-coquilles en matière synthétique isolante et rigide sont notamment utilisées dans les applications pour lesquelles il est nécessaire de ne laisser apparaître qu'un faible intervalle entre les cavités.

En effet, les demi-coquilles en matière synthétique sont le plus souvent, obtenues par moulage et il est alors plus aisé de réduire l'épaisseur des parois à leur extrémité supérieures définissant le pourtour des cavités.

Dans le cas également où les demi-coquilles sont en matière synthétique leur surface constituant les parois internes des cavités peuvent être recouvertes totalement d'une couche métallique réflectrice assurant à la fois les prises de contact des cristaux semi-conducteurs et une meilleure transmission de la lumière émise par ces derniers.

Si lesdits cristaux semi-conducteurs et leurs prises de contact doivent être surélevés sur des bossages réalisés au fond des cavités, lesdits bossages peuvent être obtenus à partir de grilles métalliques prédécoupées et surmoulées dans le fond des demi-coquilles en matière synthétique.

Dans une application préférentielle de l'invention qui fait expressément partie de celle-ci, l'élément d'affichage assure la transmission de rayonnements lumineux dans un panneau.

Selon l'invention, en effet, ce panneau comporte une pluralité d'éléments tels que décrits ci-dessus transmettant les rayonnements émis par les diodes électroluminescentes créées dans les cristaux semi-conducteurs et raccordées à un double réseau de connexions porté par un support.

Ce panneau qui peut être rendu extra-plat, sert notamment à l'affichage mais il présente un intérêt particulier dans le domaine de la signalisation routière et, en particulier, de la signalisation de véhicules automobiles.

La description qui va suivre en regard des dessins annexés fera bien comprendre comment l'invention peut être réalisée.

La figure 1 représente une vue partielle en perspective d'une portion de bande métallique comportant des demi-coquilles complémentaires.

La figure 2 illustre une vue de dessus de cette même portion de bande.

La figure 3 représente une coupe schématique d'une portion d'élément de panneau d'affichage dans une première forme préférentielle de réalisation correspondant à l'utilisation des bandes illustrées par les figures 1 et 2.

La figure 4 représente une coupe schématique d'une portion d'élément de panneau d'affichage dans une seconde forme de réalisation.

Il est à noter que, sur les figures, les dimensions sont considérablement exagérées et non proportionnées, ceci afin de rendre les dessins plus clairs.

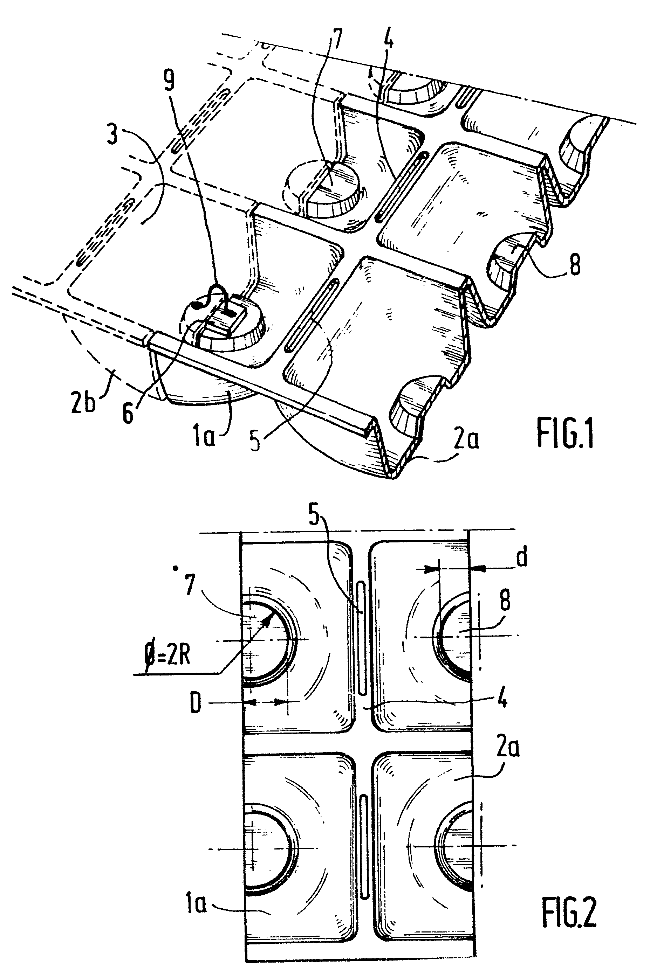

Conformément aux figures 1 et 2, et selon une première forme de réalisation, la bande dans laquelle sont réalisés les éléments de panneau d'affichage selon l'invention est obtenue à partir d'une feuille métallique dans laquelle on a formé une première série de demi-coquilles 1 et, simultanément, une seconde série de demi-coquilles 2.

Dans l'exemple choisi, les demi-coquilles 1 et 2 sont dites complémentaires, c'est-à-dire que, par exemple, les demi-coquilles 1a d'une première bande associée aux demi-coquilles 2b d'une autre bande identique telle que celle représentée partiellement sur la figure 1, constituent des cavités 3.

Les demi-coquilles 1 et 2 sont séparées entre elles par une languette 4 de faible largeur rendue éventuellement sécable à l'aide d'ouvertures 5 pratiquées dans le sens de la longueur et d'une manière discontinue.

Pour faciliter la mise en place et le soudage des cristaux semi-conducteurs 6, les demi-coquilles 1 comportent avantageusement en leur fond, une surélévation ou bossage 7. Dans ce cas, il est préférable que les demi-coquilles 2 comportent également un bossage 8 destiné à recevoir une extrémité du fil de connexions 9 relié à l'une des deux régions de la diode électroluminescente créée dans le cristal semi-conducteur 6.

Les cristaux semi-conducteurs 6 étant généralement recouverts d'une goutte de résine, il est souhaitable que l'association des bossages 7 des demi-coquilles 1 avec les bossages 8 des demi-coquilles 2 constitue un ensemble plat de configuration sensiblement circulaire dans le but de faciliter par capillarité la mise en forme de la goutte de résine qui devient alors pratiquement hémisphérique, représentant ainsi la forme la plus favorable à l'extraction du flux lumineux. C'est pourquoi lesdits bossages 7 et 8 sont choisis de forme et de dimension également complémentaires.

Ainsi, selon la figure 2, la dimension principale D du bossage semicirculaire 7 est égale au rayon R dudit bossage augmenté d'une longueur 1 égale au moins à la moitié de la largeur ou de la longueur du cristal semi-conducteur qu'il supporte, ceci afin de centrer ledit cristal au fond de la cavité. Au contraire la distance principale d du bossage semicirculaire 8 est égale au même rayon R diminuée de cette longueur 1 et d'une valeur supplémentaire égale à l'épaisseur de l'interface isolant les demi-coquilles 1 et 2.

La bande métallique telle que décrite ci-dessus est généralement obtenue par matriçage ou emboutissage d'une lamelle fine d'un matériau malléable bon conducteur de l'électricité et au pouvoir réfléchissant élevée ou rendu élevé par l'apport d'une pellicule réfléchissante, aluminium, cuivre ou laiton par exemple, ou alliage à base de fer et de nickel recouvert d'un film d'argent.

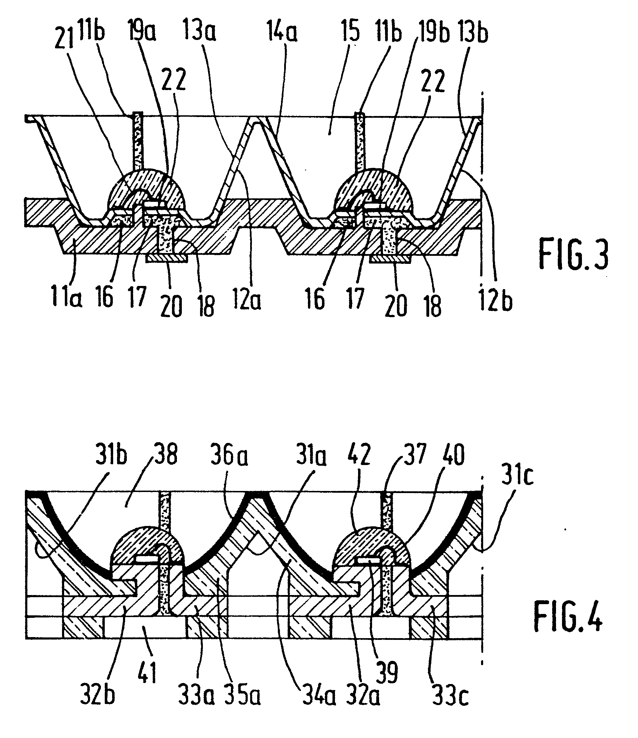

La figure 3 représente une première forme de réalisation d'un élément de panneau d'affichage comportant des bandes du type précédemment décrit.

Selon cette figure, sur une semelle isolante 11a, en matière plastique notamment, sont fixées des bandes métalliques identiques 12a, 12b . . .

Chacune de ces bandes métalliques comporte une première rangée de demi-coquilles 13a, 13b . . . parallèle à une seconde rangée d'une bande voisine, une cavité 15.

Les demi-coquilles complémentaires sont fixées entre elles à l'aide d'un film 11b de résine isolante et sont fixées respectivement à la semelle plastique 11a à l'aide de plots 16 et 17 de résine conductrice.

De préférence, dans la portion de semelle 11a située sous les demi-coquilles 13, est percé un trou 18 dans lequel est introduite une goutte de la résine conductrice 17 de manière à mettre en contact lesdites demi-coquilles 13 (donc l'une des régions des cristaux semi-conducteurs 19a, 19b . . .) avec une plage de prise de contact 20 située sous la dite semelle 11a. L'autre région des cristaux semi-conducteurs 19a, 19b ... est reliée aux demi-coquilles 14 par l'intermédiaire du fil de connexion 21.

Parfois, les cavités 15 peuvent être remplies d'une résine transparente éventuellement colorée ayant pour but de concentrer le faisceau lumineux émis par chacune des diodes électroluminescentes mais, le plus souvent, ces cavités 15 restent vides. Dans ces conditions, chaque cristal semi-conducteur 19a, 19b ... est recouvert d'une goutte de résine transparente 22 servant d'adaptateur d'indices de réfraction et de protection contre les agents atmosphériques et/ou chimiques extérieurs.

Du point de vue électrique, on constate que l'utilisation de ces bandes métalliques permet de réaliser automatiquement des combinaisons série-parallèle des cristaux 19a, 19b ...

En effet, telle que représentée partiellement sur la figure 3, la région semi-conductrice inférieure d'un type de conduction donné, dite par exemple première région d'un cristal semi-conducteur 19a est mise en contact avec la seconde région de type de conduction opposé du cristal suivant 19b par l'intermédiaire des demi-coquilles 13a et 14a et ainsi de suite. Simultanément, cette première région du cristal 19a est mise en parallèle avec la première région de tous les cristaux semi-conducteurs situés sur la même rangée de demi-coquilles de la barre métallique 12a et ainsi de suite.

La figure 4 illustre une seconde forme de réalisation d'un élément de panneau d'affichage selon l'invention.

Selon cette figure, dans une bande 31a en matière plastique isolante sont enrobés les éléments 32a et 33a d'un motif conducteur reproduit en une pluralité de fois sur la longueur de la dite bande 31a.

Ladite bande 31a est constituée de deux rangées de demi-coquilles complémentaires 34a et 35a et ces demi-coquilles sont recouvertes d'une couche d'un matériau réfléchissant 36a.

Une pluralité de bandes identiques 31a, 31b ... sont fixées entre elles à l'aide d'un film de résine isolant 37.

L'association des demi-coquilles d'une rangée d'une première bande 31a avec les demi-coquilles complémentaires d'une rangée d'une seconde bande 31b, engendrent la formation de cavités 38 etc. ...

Le film de résine isolant 37 permet ainsi de séparer électriquement les éléments 32a, 32b ... et 33a, 33c ... de motifs voisins, les motifs 32a, 32b ... portant les cristaux 39 et constituant la première connexion pour une première région desdits cristaux alors que les motifs 33a, 33c ... sont utilisés comme support des fils de connexion 40 de la seconde région des cristaux 39 avec l'extérieur.

La prise de contact sur les motifs 32a, 32b, 33a, 33c ... est rendue possible grâce à la présence de trous 41 prévus dans les bandes plastiques 31a, 31b ... à la plomb desdits motifs.

Pour parfaire la transmission lumineuse des rayonnements provenant des cristaux 39 et pour assurer la protection de ces derniers contre les agents atmosphériques et chimiques extérieurs, lesdits cristaux 39 sont recouverts d'une goutte de résine transparente 42.

## Revendications

1. Elément de panneau d'affichage formé essentiellement d'une pluralité de cristaux semi-conducteurs (6, 19, 39) dans chacun desquels sont créés au moins deux régions de types de conduction opposés formant une jonction électroluminescente et situés au fond de cavités (3, 15, 38) réfléchissant la lumière émise par ces cristaux, lesdites cavités, créées dans des bandes (12, 31) de longueur déterminée étant disposées soit en lignes, soit en colonnes, soit encore en une combinaison de lignes et de colonnes selon une configuration préalablement choisie et chacune d'entre elles comportant au moins deux plages métalliques de connexion mises respectivement en contact des deux régions du cristal semi-conducteur situé au fond, élément caractérisé en ce que chacune des bandes est constituée de deux rangées de demi-coquilles (1, 2, 13, 14, 34, 35) disposées dos à dos et engendrant des portions de cavités complémentaires, lesdites demi-coquilles de la première rangée (1, 13, 34) comportant au fond le support et la première plage de connexion des cristaux semi-conducteurs et les demi-coquilles de la seconde rangée (2, 14, 35) comportant au fond une plage métallique de prise de contact constituant la seconde connexion desdits cristaux et en ce qu'au moins deux bandes identiques sont associées de façon à être isolées entre elles dans une disposition engendrant une suite de cavités (3, 15, 38).

2. Elément selon la revendication 1, caractérisé en ce que les demi-coquilles (1, 2, 13, 14, 34, 35) de deux rangées d'une même bande engendrent des portions de cavité de volume égale et sont symétriques par rapport au plan perpendiculaire à ladite bande et séparant celle-ci en deux parties égales correspondant aux deux rangées de demi-coquilles.

3. Elément selon la revendication 1, caractérisé en ce que les demi-coquilles (1, 2, 13, 14, 34, 35) des deux rangées d'une même bande engendrent deux portions de cavité complémentaires de volumes différents, les demi-coquilles (1, 13, 34) servant de support aux cristaux semi-conducteurs étant d'une part de volume supérieur à celui des demi-coquilles (2, 14, 35) servant de support à la seconde connexion, et portant, d'autre part, en totalité lesdits cristaux (6, 19, 39) de manière telle que ceux-ci soient centrés sur l'axe optique des cavités (3, 15, 38) qu'elles engendrent avec les demi-coquilles complémentaires.

4. Elément selon l'une des revendications 1 à 3, caractérisé en ce que chaque cristal semi-conducteur (6, 19, 39) est fixé sur un bossage (7, 13, 32) élaboré sur le fond de la demi-coquille (1, 13, 34) et servant de support.

5. Elément selon l'une des revendications 1 à 4, caractérisé en ce que le point de contact entre la demi-coquille (2, 14, 35) servant de support à la seconde connexion des cristaux (6, 19, 39) et le fil de liaison (9, 21, 40) avec la région correspondante desdits cristaux est élaboré sur un bossage (8, 14, 33) formé au fond de ladite demi-coquille.

6. Elément selon l'une des revendications 1 à 5, caractérisé en ce que les demi-coquilles (1, 2, 13, 14) sont réalisées à partir de bandes métalliques relativement malléables conductrices de l'électricité et soutenues par une semelle (11a) en matière plastique isolante.

7. Elément selon l'une des revendications 1 à 5, caractérisé en ce que les demi-coquilles (34, 35) sont en matière synthétique isolante et rigide, recouverte au moins partiellement d'une couche métallique à pouvoir réfléchissant élevé.

8. Elément selon les revendications 1, 2, 3, 4, 5, 7, caractérisé en ce que les cristaux semi-conducteurs (39) et leurs prises de contact sont disposés sur des bossages (32, 33) obtenus à partir de grilles métalliques prédécoupées et surmoulées dans le fond des demi-coquilles (34, 35) en matière synthétique.

9. Panneau comportant une pluralité d'éléments conformes à l'une des revendications 1 à 8.

**Patentansprüche**

1. Anzeigeelement, bestehend im wesentlichen aus einer Vielzahl von Halbleiterkristallen (6, 19, 39), in denen je zumindest zwei Bereiche von entgegengesetzten Leitfähigkeitstypen geschaffen werden, die eine elektro-lumineszierende Verbindung darstellen und sich am Boden der Höhlungen (3, 15, 38) befinden, die das von diesen Kristallen ausgestrahlte Licht reflektieren, wobei diese Höhlungen in Streifen (12, 31) mit einer gegebenen Länge angeordnet sind und entweder in Zeilen oder in Spalten, oder auch in einer Kombination von Zeilen und Spalten nach einer zuvor ausgewählten Konfiguration angeordnet sind und jede von ihnen zumindest zwei metallene Kontaktzonen enthält, die zum Kontaktieren der zwei Bereiche des am Boden befindlichen Halbleiterkristalls dienen, dadurch gekennzeichnet, dass jeder Streifen aus zwei Reihen von Halbschalen (1, 2, 13, 14, 34, 35) besteht, die mit ihren Rücken aneinander liegen und ergänzende Höhlungsteile bilden, wobei die Halbschalen der ersten Reihe (1, 13, 34) am Boden den Träger in die erste Kontaktzone der Halbleiterkristalle und die Halbschalen der zweiten Reihe (2, 14, 35) am Boden eine metallische Kontaktzone enthalten, die die zweite Verbindung der Kristalle darstellt, und dass zumindest zwei gleiche Streifen derart in voneinander isolierter Stellung zusammengebracht werden, dass sie eine Reihe von Höhlungen (3, 15, 38) darstellen.

2. Anzeigeelement nach Anspruch 1, dadurch gekennzeichnet, dass die Halbschalen (1, 2, 13, 14, 34, 35) aus zwei Reihen eines gleichen Streifens volumengleiche Höhlungsteile bilden und planparallel zum Streifen symmetrisch sind und diesen Streifen in zwei gleiche Teile entsprechend den zwei Halbschalenreihen voneinander trennen.

3. Anzeigeelement nach Anspruch 1, dadurch gekennzeichnet, dass die Halbschalen (1, 2, 13, 14, 34, 35) von zwei Reihen eines gleichen Streifens zwei ergänzende Höhlungsteile mit verschiedenen Volumen bilden, wobei die Halbschalen (1, 13, 34) zum Tragen der Halbleiterkristalle dienen, die einerseits ein grösseres Volumen haben als die Halbschalen (23, 14, 35), die als Träger für die zweite Verbindung dienen, und andererseits insgesamt die Kristalle (6, 9, 39) derart tragen, dass sie auf die optische Achse der Höhlungen (3, 15, 38) zentriert sind, die sie mit den ergänzenden Halbschalen bilden.

4. Anzeigeelement nach einem der Ansprüche 1 bis 3, dadurch gekennzeichnet, dass jeder Halbleiterkristall (6, 19, 39) auf einer Warze (7, 13, 32) befestigt ist, die am Boden der Halbschale (1, 13, 34) vorgesehen ist und als Träger dient.

5. Anzeigeelement nach einem der Ansprüche 1 bis 4, dadurch gekennzeichnet, dass der Kontaktpunkt zwischen der Halbschale (2, 14, 35), die als Träger für die zweite Verbindung der Kristalle (6, 19, 39) dient, und dem Verbindungsdraht (9, 21, 40) mit dem entsprechenden Bereich der Kristalle auf einer Warze (8, 14, 33) befestigt ist, die am Boden der genannten Halbschale gebildet ist.

6. Anzeigeelement nach einem der Ansprüche 1 bis 5, dadurch gekennzeichnet, dass die Halbschalen (1, 2, 13, 14) aus Metallstreifen hergestellt sind, die relativ verformbar und leitfähig sind und von einer Platte (11a) aus isolierendem Kunststoff getragen werden.

7. Anzeigeelement nach einem der Ansprüche 1 bis 5, dadurch gekennzeichnet, dass die Halbschalen (34, 35) aus einem synthetischen, isolierenden und harten Material bestehen, das zumindest teilweise mit einer Metallschicht mit grosser Reflektionsfähigkeit bedeckt sind.

8. Anzeigeelement nach einem der Ansprüche 1, 2, 3, 4, 5, 7, dadurch gekennzeichnet, dass die Halbleiterkristalle (39) und ihre Kontakte auf Warzen (32 und 33) angeordnet sind, die aus vorgeschnittenen Metallgittern gewonnen und am Boden der Halbschalen (34 und 35) in synthetischem Material angebracht werden.

9. Platte mit einer Vielzahl von Elementen nach einem oder mehreren der Ansprüche 1 bis 8.

**Claims**

1. Display panel element essentially comprising a plurality of semiconductor crystals (6, 19, 39) in each of which are created at least two regions of opposite conductivity types forming an electroluminescent junction and situated at the bottom of cavities (3, 15, 38) reflecting the light emitted by said crystals, the said cavities created in strips (12, 31), of a given length being disposed either in lines or in columns, or in a combination of lines and columns according to a previously chosen configuration and each of them comprising at least two metallic connection pads made respectively to contact the two regions of the semiconductor crystal situated at the bottom, characterized in that each of the strips is constituted by two rows of half-shells (1, 2, 13, 14, 34, 35), disposed in back-to-back arrangement and producing complementary cavity portions, the half-shells of the first row (1, 13, 34) comprising at their bottom the support and the first connection pad of the semiconductor crystals, and the half-shells of the second row (2, 14, 35) comprising at their bottom a metallic contact pad constituting the second connection of the said crystals, and in that at least two identical strips are associated in such a manner that they are insulated from each other in a disposition producing a series of cavities (3, 15, 38).

2. Element as claimed in Claim 1, characterized in that the half-shells (1, 2, 13, 14, 34, 35) of the two rows of one and the same strip produce cavity portions of equal volume and are symmetrical with respect to the plane perpendicular to the said strip and separating same into two equal parts corresponding to the two rows of half-shells.

3. Element as claimed in Claim 1, characterized in that the half-shells (1, 2, 13, 14, 34, 35) of the two rows of one and the same strip produce two complementary cavity portions of different volumes, the half-shells (1, 13, 34) serving to support the semiconductor crystals being on the one hand of a higher volume than that of the half-shells (2, 14, 35) serving to support the second connection, and wholly supporting on the other hand the said crystals (6, 19, 39) in such a manner that they are centred on the optical axis of the cavities (3, 15, 38), produced by the complementary half-shells.

4. Element as claimed in any of Claims 1 to 3, characterized in that each semiconductor crystal (6, 19, 39) is fixed on a boss (7, 13, 32) produced at the bottom of the half-shell (1, 13, 34) and serving as a support.

5. Element as claimed in any one of Claims 1 to 4, characterized in that the contact point between the half-shell (2, 14, 35) serving to support the second connection of the crystals (6, 19, 39) and the connection wire (9, 21, 40) connected to the corresponding region of the said crystals is produced on a boss (8, 14, 33) formed at the bottom of said half-shell.

6. Element as claimed in any one of Claims 1 to 5, characterized in that the half-shells (1, 2, 13, 14) are produced from relatively malleable electrically conducting metallic strips which are supported by a plate (11a) of insulating plastic material.

7. Element as claimed in any one of Claims 1 to 5, characterized in that the half-shells (34, 35) are of an insulating and rigid synthetic material covered at least partly by a metallic layer having a high reflecting power.

8. Element as claimed in Claims 1, 2, 3, 4, 5, 7, characterized in that the semiconductor crystals (39) and their contacts are disposed on bosses (32, 33) obtained from metallic grids pre-cut and moulded in the bottom of the half-shells (34, 35) of synthetic material.

9. Panel comprising a plurality of elements as claimed in any one of Claims 1 to 8.

FIG.1

FIG.2

FIG.3

FIG.4